Europäisches Patentamt

**European Patent Office**

**Office européen des brevets**

(19)

(11) Veröffentlichungsnummer: **0 051 174**
A2

(12)

# EUROPÄISCHE PATENTANMELDUNG

(21) Anmeldenummer: **81108291.6**

(22) Anmeldetag: **13.10.81**

(51) Int. Cl.³: **H 05 K 3/26**
H 01 L 21/263, H 05 H 1/24
//C23F1/00

(30) Priorität: **04.11.80 DE 3041551**

(43) Veröffentlichungstag der Anmeldung:
**12.05.82 Patentblatt 82/19**

(84) Benannte Vertragsstaaten:
**FR GB IT NL**

(71) Anmelder: **SIEMENS AKTIENGESELLSCHAFT Berlin
und München
Postfach 22 02 61
D-8000 München 22(DE)**

(72) Erfinder: **Brabetz, Bernhard, Dipl.-Ing.
Böttcherstrasse 33
D-8000 München 60(DE)**

(72) Erfinder: **Mann, Wolfgang
Lindenstrasse 18
D-8150 Holzkirchen(DE)**

(72) Erfinder: **Steiner, Rainer, Dipl.-Phys
Schneemannstrasse 1
D-8000 München 70(DE)**

(54) **Elektroden für Plasma-Ätzanlage.**

(57) Zum Reinigen von Bohrungen in Leiterplatten ist das Plasma-Ätzen bekannt. Bei den auf dem Markt befindlichen Anlagen mit Plattenelektroden und Ringelektroden sind die Abtragsraten zu klein und die Gleichmäßigkeit des Abtrags im Reaktor nicht ausreichend. Nach der Erfindung werden die Elektroden so angeordnet, daß sich jede Leiterplatte in einem eigenen ionenfreien Raum befindet. Dabei ist jede Leiterplatte von einer mit einer Hochfrequenzquelle verbundenen kastenförmigen Elektrode umgeben.

FIG 3

EP 0 051 174 A2

Croydon Printing Company Ltd.

SIEMENS AKTIENGESELLSCHAFT
Berlin und München

Unser Zeichen
VPA 80 P 7 1 9 1 E

Elektroden für Plasma-Ätzanlage.

Die Erfindung betrifft die konstruktive Ausbildung der parallel angeordneten Elektroden im Reaktor einer Plasma-Ätzanlage für Leiterplatten.

Leiterplatten werden oft zu mehreren Lagen zusammenlaminiert. Die Schaltungen auf den einzelnen Lagen werden durch durchkontaktierte Bohrlöcher miteinander verbunden. Um diese Verbindung herzustellen, wird ein Loch gebohrt, das die Schaltung auf einer bestimmten Lage durchschneidet. Dann werden die Bohrlöcher mit einer Kupferschicht versehen, normalerweise durch eine stromlose Kupferplattierung. Die Kupferplattierung erzeugt eine Leitungsbahn, die alle Schaltungen umschließt, welche von diesem Loch durchschnitten wurden.

Ein allgemeines Problem, das bei der Anfertigung dieser gegenseitigen Verbindungen auftritt, ist die Verschmierung beim Bohren. Diese organische Verschmierung muß entfernt werden, bevor das Loch durchkontaktiert wird. Falls die Verschmierung nicht entfernt wird, werden die einzelnen Schaltungen von dem durchkontaktierten Bohrloch isoliert.

Die Entfernung von Verschmierungen mit Hilfe des sogenannten Plasma-Ätzens ist bekannt. Dabei werden Gasmoleküle in einer Gasentladung in reaktive Bruchstücke aufgespalten, nämlich in Elektronen, Ionen und neutrale Radikale, die man chemisch mit der zu ätzenden Oberfläche reagieren läßt. Die vorhandenen Anlagen zum Reinigen von Bohrungen in Leiterplatten mittels Gasplasma arbeiten aber nicht zufriedenstellend. Die Abtragsraten sind zu

Wed 1 Plr/29.10.1980

klein, und die Gleichmäßigkeit des Abtrags im Reaktor ist nicht ausreichend.

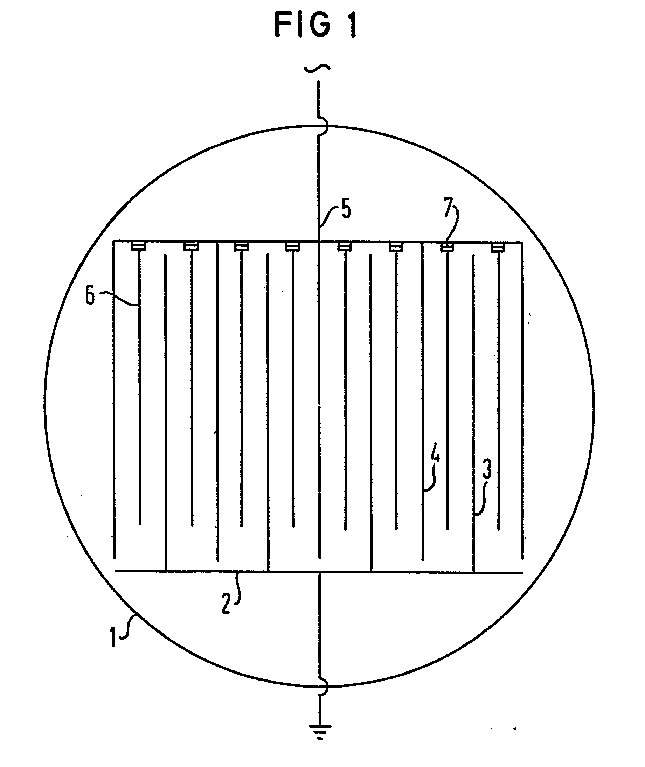

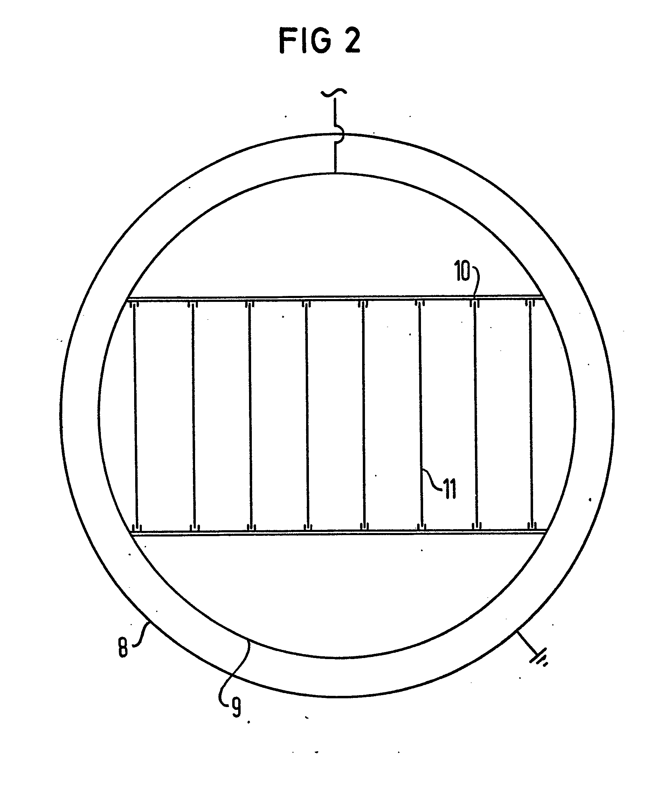

Zur Zeit sind zwei konstruktive Konzepte von Plasma-Ätzanlagen bekannt. Es handelt sich dabei um Anlagen mit Plattenelektroden, die im Prinzip in der Figur 1 dargestellt sind, und um Anlagen mit Ringelektroden nach Figur 2.

In einem zylindrischen Reaktorgehäuse 1 verläuft in der Figur 1 im unteren Teil eine geerdete Elektrodenhalterung 2, von der mehrere senkrechte Elektroden 3 nach oben ausgehen. Parallel zu diesen Elektroden sind in den Zwischenräumen Elektroden 4 angeordnet, die über eine Verbindung 5 mit einer nicht dargestellten Hochfrequenz-Spannungsquelle verbunden sind. Zwischen den gegenseitigen Elektroden 3 und 4 und parallel zu ihnen sind Leiterplatten 6 vorgesehen, die jeweils in einer Leiterplattenaufnahme 7 gehalten werden. Die Gasführung ist weder in dieser Figur noch in den weiteren Figuren dargestellt. Bei dem Material der Elektroden handelt es sich um gelochtes Aluminiumblech.

Bei dem in der Figur 1 schematisch dargestellten Arbeitsprinzip befinden sich die Leiterplatten direkt im Plasma, d. h. in der Entladungszone. Die aktiven Spezies sind also während des gesamten Ätzprozesses zusammen mit den Ionen und Elektronen im Plasma. Dadurch tritt eine Rekombination der aktiven Spezies mit den Ionen auf, was zur Folge hat, daß die Abtragsrate sehr gering ist.

In der Figur 2 ist eine Plasma-Ätzanlage mit Ringelektroden im Prinzip dargestellt. Bei dieser Anordnung ist das Reaktorgehäuse 8 die geerdete Elektrode und der dazu parallel angeordnete Mantel die an einer Hochfrequenz-Spannungsquelle angeschaltete Elektrode 9. Diese Elektrode besteht aus gelochtem Aluminiumblech. Zwischen einer Leiterplattenaufnahme 10 sind parallel zueinander angeordnete Leiterplatten 11 vorgesehen.

Bei dem in der Figur 2 dargestellten Arbeitsprinzip werden die aktiven Spezies (neutral) vor dem Ätzprozeß vom
Plasma getrennt und haben daher keine Gelegenheit zur
Rekombination. Die Ätzfähigkeit ist also weitaus größer
als bei den Plattenanlagen nach Figur 1. Die Gleichmäßigkeit der Rückätzung in Bezug auf den Ort im Reaktor
ist jedoch unbefriedigend. Die Ursache dafür ist, daß bei
dem Prinzip der Ringelektrode nach Figur 2 die äußeren
Leiterplatten alle weiteren abschirmen.

Der Erfindung liegt die Aufgabe zugrunde, eine Plasma-Ätzanlage zum Reinigen von Bohrungen in Leiterplatten zu
konzipieren, die gesteigerte Abtragsraten und eine größere
Gleichmäßigkeit des Abtrags gewährleistet. Diese Aufgabe
wird nach der Erfindung dadurch erreicht, daß sich jede
Leiterplatte in einem eigenen ionenfreien Raum befindet.
Dadurch wird sichergestellt, daß keine Rekombination
stattfinden kann und damit die Abtragsrate optimal ist.
Ferner ist ein gegenseitiges Abschirmen der Leiterplatten
nicht möglich und damit der Abtrag an jeder Leiterplatte
gleich groß. Mit der Ausbildung nach der Erfindung werden
die Vorteile der Platten- und der Ringelektrode gleichzeitig erreicht.

Nach einer Weiterbildung der Erfindung ist jeweils eine
Leiterplatte von einer mit einer Hochfrequenz-Spannungsquelle verbundenen kastenförmigen Elektrode umgeben. Mit
kastenförmig soll zum Ausdruck gebracht werden, daß die
Elektroden vorn und hinten offen sind. Durch die
parallele Anordnung der Leiterplatten in einem entsprechenden Kasten wird ein gleichmäßiger Abtrag in Bezug
auf den Ort an der Leiterplatte gewährleistet.

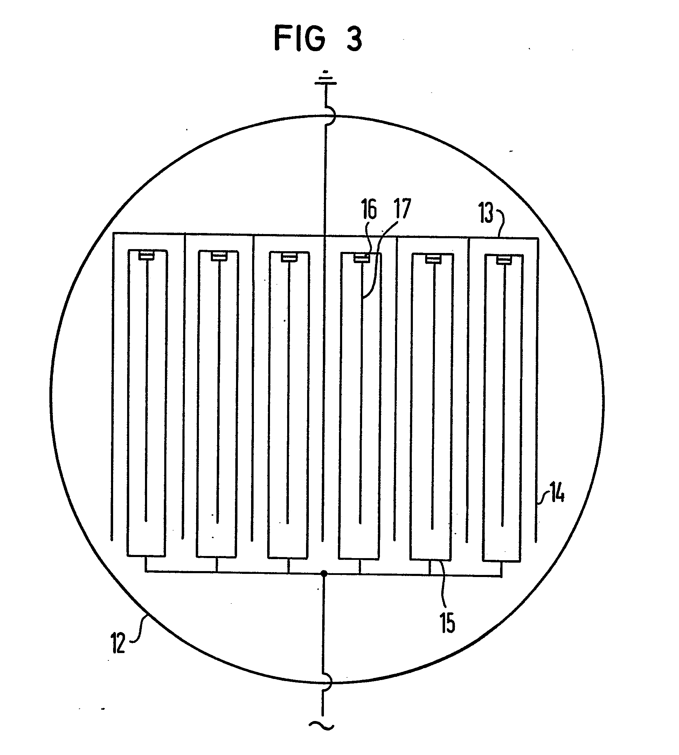

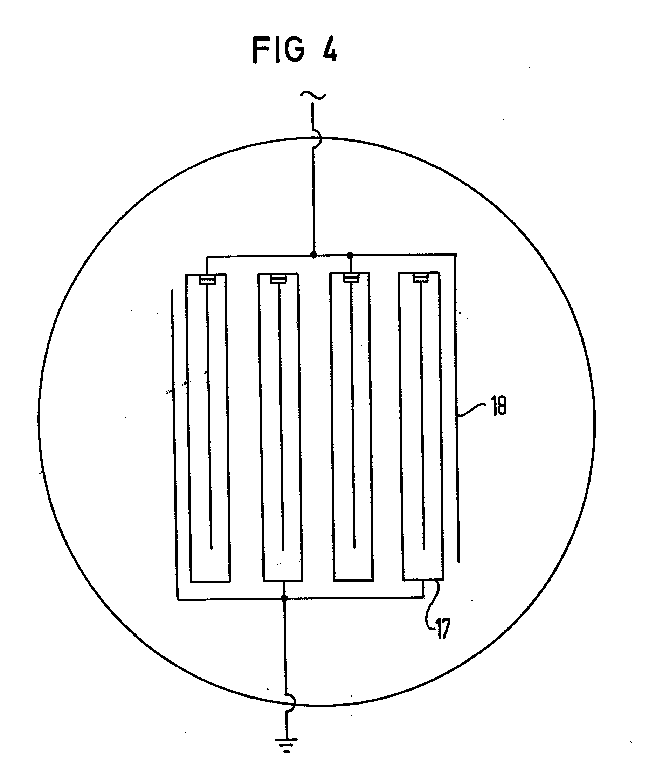

Die Erfindung wird an den Figuren 3 und 4 erläutert. Es zeigen:

Figur 1 eine Schnittdarstellung von vorn einer Plasma-Ätzanlage mit Plattenelektroden,

Figur 2 in derselben Darstellungsweise eine Plasma-Ätzanlage mit Ringelektroden,

Figur 3 die konstruktive Ausgestaltung der Elektroden einer Plasma-Ätzanlage und

Figur 4 ein weiteres Ausführungsbeispiel.

In einem zylindrischen Reaktorgehäuse 12 ist im oberen Teil der Figur 3 eine Halterung 13 angeordnet, von der aus sich mehrere Elektroden 14 senkrecht parallel nach unten erstrecken. Zwischen diesen Elektroden 14 sind kastenförmige Elektroden 15 vorgesehen, die mit einer nicht dargestellten Hochfrequenz-Spannungsquelle verbunden sind. In diesen kastenförmigen Elektroden befinden sich an Leiterplattenaufnahmen 16 parallel zwischen die kastenförmigen Elektroden 15 eingebrachte Leiterplatten 17.

Figur 4 zeigt eine andere mögliche Realisierung der Erfindung. Die Elektrodenkästen 17 sind hier abwechselnd mit Masse und der Hochfrequenzspannungsquelle verbunden. Lediglich am linken und rechten Rand befinden sich noch plattenförmige Elektroden 18.

Die Anordnung nach der Erfindung ist nicht auf die Darstellung in den Figuren 3 und 4 beschränkt. Sie könnte z. B. auch um 90° oder 180° gedreht realisiert werden. Außerdem ist eine andere Anzahl von Kästen möglich. Auch kann das Reaktorgehäuse quaderförmig anstatt zylinderförmig ausgeführt werden.

2 Patentansprüche

4 Figuren

0051174

- 5 -   VPA 80 P 7 1 9 1 E

Patentansprüche.

1. Konstruktive Ausbildung der parallel angeordneten Elektroden im Reaktor einer Plasma-Ätzanlage für Leiterplatten, d a d u r c h   g e k e n n z e i c h n e t , daß sich jede Leiterplatte (17) in einem eigenen ionenfreien Raum befindet (Figuren 3 und 4).

2. Elektrodenausbildung nach Anspruch 1, d a d u r c h   g e k e n n z e i c h n e t , daß jeweils eine Leiterplatte (17) von einer mit einer Hochfrequenz-Spannungsquelle verbundenen kastenförmigen Elektrode (15) umgeben ist.

FIG 1

FIG 2

## FIG 3

FIG 4